# EUROPEAN PATENT APPLICATION

(11) **EP 2 166 568 A2**
(43) Date of publication of application: **24.03.2010**
(21) Application number: 09170562.4
(22) Date of filing: 17.09.2009
(51) Int. Cl.: H01L 23/36, H01L 23/433

(54) **An integrated circuit**

(30) Priority: 19.09.2008 TR 200807159
(71) Applicant: Vestel Elektronik Sanayi ve Ticaret A.S., 45030 Manisa (TR)
(72) Inventor: Basarir, Cenk, 45030 Manisa (TR)
(74) Representative: Cayli, Hülya

(57) **Abstract**

This invention describes an integrated circuit (1) and examples of heat sinks (2) adapted to that circuit. The integrated circuit (1) has legs (6) which are used for the soldering of at least one side of it with the printed circuit board and has a body which is in the shape of a prism. This invention aims to adapt a highly thermal conductive heat sink (2) placed on at least one side surface (4, 4') or on at least one of the upper (3) and lower (5) surfaces along with the side surface.

## Description

### Technical Field

This invention is related to the heat sinks used for cooling the integrated circuits and the methods they are applied on the integrated circuits.

### Background Art

In order to transfer the heat generated during the operation of integrated circuits to the printed circuit boards on which they are placed or to the various cooler elements fixed onto the integrated circuits, the heat sinks of different shapes which have at least one part can be installed on the lower or upper part of the said integrated circuits.

The heat sinks installed only on the lower part of the integrated circuit are generally used in the multi-layer printed circuit boards for reflow soldering of the surface mounted integrated circuits.

The heat sinks installed only on the upper part of the integrated circuit are usually used both in the multi - layer printed circuit boards and in the single-layer printed circuit boards. However, in these types of assembly, a metal cooler block to which the heat would be transferred is certainly to be used on the integrated circuit.

Especially the use of integrated circuits with a heat sink on its lower part in single - layer printed circuit boards are fairly limited and without some additional units such as metal cooling blocks, the use of these integrated circuits on upper limits is very hard. The reason for this is that during the wave soldering process of the single-layer printed circuit boards, the board receives soldering by passing through a soldering pool and in order to prevent the integrated circuits on the lower part from falling into the soldering pool in course of the soldering process, prior to the automated typesetting, some adhesive material is applied to the spot on printed circuit board where the integrated circuit would be seated. This adhesive material keeps integrated circuit from falling down into the soldering pool in course of the soldering process. Nevertheless, the adhesive serves as an insulation material between the printed circuit board and the integrated circuit, whose thermal conductivity is low. Therefore, the transfer of heat generated on the integrated circuit to the printed circuit board gets harder and due to the overheating of the integrated circuit, its use on upper limits is limited.

Furthermore, the patent applications US2008111217, JP2007234913 and JP5315712 describe heat sinks of various forms used for the cooling of an integrated circuit. But these heat sinks are complex and expensive to produce.

### Brief Description of Invention

This invention relates to heat sinks used for cooling the integrated circuits on printed circuit boards. For instance, owing to the fact that single-layer boards are cheaper with respect to the other multi-layer boards, different heat sinks are designed so that the integrated circuits with heat sinks could be used on single-layer boards. In these designs, the heat sinks are formed in such a way to cover at least one side surface of the integrated circuits or to cover at least one of the upper or lower surfaces along with the side surface. These can be U - shaped, covering upper or lower surface besides the side surfaces or they may be situated only on the side surfaces as well. While the integrated circuits that have heat sinks on their side surfaces pass through the soldering pools in reflow soldering machines, the soldering regions which neighbor the side surfaces and are on the printed circuit are soldered and the soldering of the heat sinks to these regions is also ensured. Therefore, heat transfer between the integrated circuit and the printed circuit board can be ensured.

### Aim of Invention

The aim of this invention is to adapt a heat sink onto at least one side surface or onto at least one of the upper or lower surfaces along with the side surface.

Another aim of this invention is to ensure quicker cooling of integrated circuits by means of the heat sinks adapted onto said integrated circuits.

Yet another aim of this invention is to ensure soldering of the heat sinks on the integrated circuits to the printed circuit boards on which said integrated circuits are placed.

Another aim of this invention is to provide heat sinks for integrated circuits, which are easier to mount, cheaper and more effective.

### Brief Description of Drawings

An exemplary integrated circuit of this invention is illustrated in the appended figures in which;
Figure 1 is a perspective view of an exemplary integrated circuit onto whose side and upper surfaces a heat sink is adapted.
Figure 2 is a perspective view of an exemplary integrated circuit onto whose side and lower surfaces a heat sink is adapted.
Figure 3 illustrates different perspective views of an exemplary integrated circuit onto whose side surfaces a heat sink is adapted.

The parts illustrated in these figures are individually assigned and reference numerals can be listed as:
Integrated circuit (1)
Heat sink (2)
Upper surface (3)
Side surfaces (4, 4')
Lower surface (5)
Legs (6)

### Disclosure of Invention

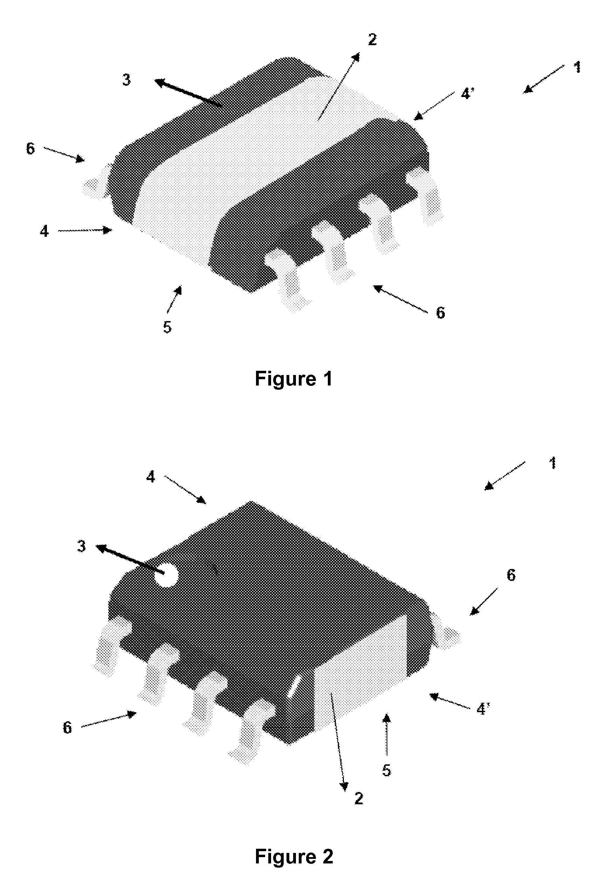

In Figures 1 - 3, examples of integrated circuits subject matter of this invention and the heat sinks adapted onto those circuits are illustrated. As it is already known, an integrated circuit (1) has a body generally in the shape of a prism which has the legs (6) used for soldering at least one side of the circuit to the printed circuit board. The aim of this invention is to adapt a highly thermal conductive heat sink (2) fixed on at least one side surface (4, 4') of the body or on at least one of the upper (3) or lower (5) surfaces along with the said side surface.

Figure 1 illustrates a perspective view of an exemplary integrated circuit onto whose upper and side surfaces a heat sink is adapted. In this embodiment, a heat sink (2) located on the upper surface (3) and on at least one side surface (4, 4') of the integrated circuit (1) is shown.

Figure 2 illustrates a perspective view of an exemplary integrated circuit onto whose side and lower surfaces a heat sink is adapted. In this embodiment, a heat sink (2) located on the lower surface (5) and on at least one side surface (4, 4') of the integrated circuit (1) is shown.

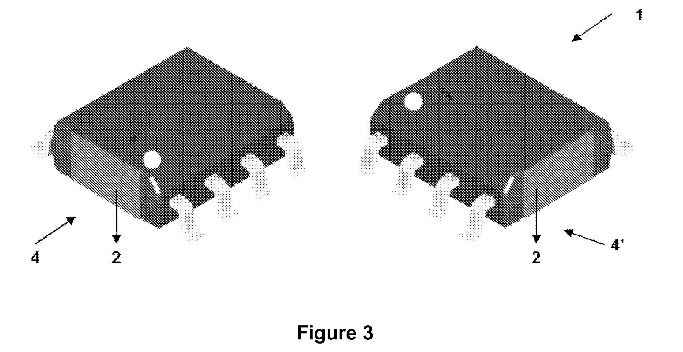

Figure 3 shows different perspective views of an exemplary integrated circuit onto whose side surfaces a heat sink is adapted. In this embodiment, a heat sink (2) located on both side surfaces (4, 4') of the integrated circuit (1) is shown.

As clearly seen from the examples above, heat sinks (2) may be fixed onto different surfaces of the integrated circuits (1) in different sizes. The important point here is to place a heat sink (2) on at least one side surface (4, 4') or on at least one of the upper (3) or lower (5) surfaces along with the side surface, in a configuration which will allow the most effective cooling of the integrated circuit (1).

Especially during the soldering process of heat sinks (2) located on the side surfaces (4, 4') and on the lower surface (5) to the printed board, e.g. during wave and reflow soldering processes, the heat sinks (2) are ensured to be fixed to the printed circuit board by means of soldering. In this way, the fixing of heat sinks (2) to the board by means of soldering is provided as well as ensuring the heat to be transferred from the integrated circuit to the printed circuit board.

The heat sinks (2), placed on the integrated circuit (1) of this invention are pressed on the related surface of the integrated circuit (1) from a highly thermal conductive material in the form of tape or they are fixed by means of an adhesive. The high thermal conductivity of the adhesive is also important for the effectiveness of cooling process. As another alternative embodiment, during the mould production of the body of integrated circuit (1), the said heat sink (2) may be situated in the mould and a heat sink (2) integrated to the body of integrated circuit (1) may be provided.

## Claims

1. An integrated circuit (1) **characterized in that**; it comprises at least one heat sink (2) with high thermal conductivity, placed on at least one side surface (4, 4') or on at least one of the upper (3) or lower (5) surfaces along with the side surface of the circuit (1).

2. An integrated circuit (1) according to Claim 1, **characterized in that** the heat sink (2) is on at least one side surface (4, 4').

3. An integrated circuit (1) according to Claim 1, **characterized in that** the heat sink (2) is on the upper surface (3) along with at least one side surface (4, 4').

4. An integrated circuit (1) according to Claim 1, **characterized in that** the heat sink (2) is on the lower surface (5) along with at least one side surface (4, 4').

5. An integrated circuit (1) according to Claim 1, **characterized in that** the heat sink (2) is on the upper surface (3) and lower surface (5) along with at least one side surface (4, 4').

6. An integrated circuit (1) according to Claims 1 - 5, **characterized in that** the heat sink (2) is in the form of a tape.

7. An integrated circuit (1) according to Claims 1 - 6, **characterized in that** the heat sink (2) is pressed onto the related surface of the circuit (1).

8. An integrated circuit (1) according to Claims 1 - 6, **characterized in that** the heat sink (2) is fixed to the related surface of the circuit (1) by means of an adhesive.

9. An integrated circuit (1) according to Claim 8, **characterized in that** the adhesive has high thermal conductivity.

10. An integrated circuit (1) according to Claims 1 - 6, **characterized in that** the heat sink (2) is moulded together with the body of the integrated circuit.
